# EUROPEAN PATENT APPLICATION

(11) **EP 0 657 926 A2**
(43) Date of publication of application: **14.06.1995**
(21) Application number: 94308856.7
(22) Date of filing: 30.11.1994
(51) Int. Cl.: H01L 21/768

(54) **Window processing for silicon components**

(30) Priority: 07.12.1993 US 163443
(71) Applicant: AT&T Corp., New York, NY 10013-2412 (US)
(72) Inventor: Maury, Alvaro, Orlando, Florida 32819 (US)
(74) Representative: Johnston, Kenneth Graham

(57) **Abstract**

A method for forming a contact window in an oxide layer formed on a semiconductor substrate is disclosed. The method comprises the steps of: implanting a dopant into the oxide layer, followed by isotropic and anisotropic etching of a window area of the oxide. The steps form. the contact window in the oxide layer at the window area permitting a sub-micron linewidth contact layer to be formed within the contact window. The invention avoids the formation of re-entrant window wall edges in the oxide layer.

## Description

### Field of the Invention

The invention generally relates to the field of semiconductor processing, and more particularly, to a method for improved step coverage in window processing of silicon components.

### Related Art

The present invention addresses a subset of the large number of operations required to fabricate a silicon semiconductor component. The present disclosure will thus concentrate on only the steps that are relevant to the present invention.

Modern VLSI devices incorporate multiple levels of metallization. The metal layers are separated by an insulator, typically silicon dioxide (SiO₂). In order to make electrical contacts between the metal layers, it is necessary to pattern contact holes (windows or vias) prior to the deposition of the top metal. the contact holes are first defined by photolithography using a resist later deposited on the silicon dioxide film. With the resist as a mask, the windows are made by etching the silicon dioxide at the exposed regions. In past generations of technology (minimum feature sizes larger than about 2 microns), wet etching of the oxide with HF solutions could be used. As the feature sizes have shrunk below 1 micron, wet etching is no longer a viable alternative, since it cannot provide the tight dimensional control and process reproducibility required for sub micron windows.

Dry etching methods are particularly suitable for VLSI processing because of their ability to transfer resist patterns with high fidelity. (See, for example, C.J. Mogab, "Dry Etching", *VLSI Technology*, Edited by S.M. Sze, Ch. 8, p. 303, McGraw-Hill (1983).) Basically, dry etching of silicon dioxide is performed by using a plasma to create CFₓ (x≦3) radicals which react with SiO₂ in preference to Si. The reaction products subsequently desorb from the surface, with the overall reaction being initiated and/or accelerated by energetic ions extracted from the plasma. In terms of determining the type of profile obtained in a window with dry etching, a very important parameter to consider is bias. Bias is defined as the difference in lateral dimension between the etched image and the mask image. A zero-bias process produces a vertical edge profile coincident with the edge of the mask. The pattern is transferred in this case with perfect fidelity. This represents the extreme of anisotropic etching. When the edge rate is independent of direction, that is, the vertical and horizontal etch rates are equal, the edge profiles appears as a quarter-circle after etching has been carried to completion. In this case of isotropic etching, the bias is twice the film thickness.

The window profile determines to a great extent the degree of aluminum step coverage, and thus device reliability. Among a variety of approaches to shape the windows for enhanced metal coverage, the funnel shaped or "wine glass" is commonly used. Basically, the oxide is etched in two steps. During the first part, conditions are used to produce isotropic etching. For the last part, the conditions are changed to result in anisotropic etching. The net result is a window which is wider at the top than at the bottom. In trying to implement this process to open windows in BPSG (Boro-Phospho-Silicate Glass), problems have been encountered. Due to previous process steps, namely a high temperature, flow of the glass, the top ∼500 Angstroms of the oxide etch at a slower etch rate than the bulk, during the isotropic etch. This results in re-entrant corners (called hooks), which are potential sites for metal failure. Thus, what is desired is a window processing method that yields improved step coverage and minimal additional processing steps.

### Summary of the Invention

The present invention is directed to a method for achieving a window taper in the fabrication of silicon semiconductor components. The window taper generated according to the present invention achieves superior step coverage.

The inventive method includes an implant step which creates a damaged layer in the oxide layer. The implant step is followed by an isotropic window etch and an anisotropic window etch. According to the inventive method, the oxide layer etches faster during the isotropic window etch, and thus, eliminates the troublesome re-entrant edge at the top of the window.

The inventive method is fully compatible with existing window processing methods, because of the inherent accuracy and repeatability of the implant step.

The foregoing and other features and advantages of the present invention will be apparent from the following more particular description of the preferred embodiments of the invention, as illustrated in the accompanying drawings.

### Brief Description of the Drawings

The invention will be better understood if reference is made to the accompanying drawings in which:

Figure 1 shows a representative, high-level flowchart of the method steps according to the present invention.

Figures 2A-2D show scanning electron microscope (SEM) cross-sectional views of the step coverage of aluminum deposited according to a standard process.

Figure 3A-3D show scanning electron microscope (SEM) cross-sectional views of the step coverage of aluminum deposited according to a second standard process.

Figure 4A-4D show scanning electron microscope (SEM) cross-sectional views of the step coverage of aluminum deposited according to the present invention.

In the figures, like reference numbers indicate identical or functionally similar features. Also in the figures, the left-most digit of each reference number corresponds to the figure in which the reference number is first used. No attempt has been made to depict true dimensions and/or proportions.

### Detailed Description of the Preferred Embodiments

The preferred embodiment of the present invention will now be discussed in detail. While specific features, configurations and arrangements are discussed, it should be understood that this is done for illustration purposes only. A person skilled in the relevant art will recognize that other steps, configurations and arrangements may be used without departing from the spirit and scope of the invention.

Further, background material concerning semiconductor solid-state physics may be found in a number of publicly available references including two books by S.M. Sze, titled: *Physics of Semiconductor Devices*, John Wiley and Sons, Inc., New York (1981), and *Semiconductor Devices, Physics and Technology*, John Wiley and Sons, Inc., New York (1985), both of which are incorporated herein by reference.

The inventor has discovered an improved method for window processing of silicon components. The present invention is an improvement over the results achieved with the "wine glass" window discussed in the Related Art section.

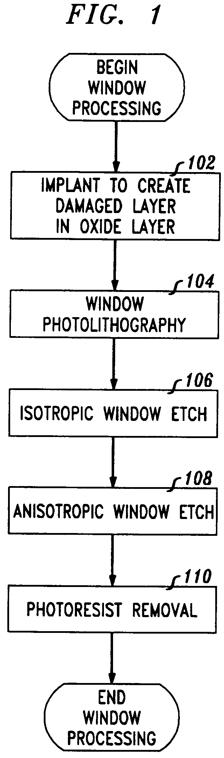

Figure 1 is a representative, high-level flowchart of the steps of the present invention. As mentioned above, the present disclosure will concentrate on only the steps that are relevant to the present invention. Thus, the window processing method of the present invention begins with a silicon substrate having an oxide layer (e.g., SiO₂) deposited thereon according to well known techniques, such as chemical vapor deposition (CVD), or the like.

An implant is performed in a step 102 to create a damaged layer in the oxide layer. The damaged layer acts to enhance the rate of lateral etching during subsequent isotropic window etching. (See U.S. Patent No. 3,769,109 for a discussion of damaged layers in thermally grown SiO₂ caused by ion-implanting.)

Although the present invention is also based on a modification the micro-structure of the oxide by ion implant to enhance the lateral etch rate of the top layer, there are fundamental differences between this application and U.S. Patent No. 3,769,109. That patent was developed for the particular case of wet etching of the windows. This method is no longer used by reasons previously discussed. In addition, the mechanisms involved in dry etching are for the most part very different from wet etching. It is thus not evident that techniques used in wet etching could be extended to plasma enhanced, or dry etching. Previous approaches to improve the taper of the windows with dry etch, have concentrated on the etching conditions, and not on modifying the oxide structure.

Thus, according to the present invention, the oxide layer is implanted with either phosphorous, silicon or arsenic, prior to window photolithography and dry etching. The dose and energy of the implant are optimized to obtain the desired window profile. The tool preferably used for the implant is an Eaton Nova Implanter, model NV-GSD (manufactured by Eaton Corporation, Semiconductor Equipment Division, 108 Cherry Hill Drive, Beverly, Massachusetts, 01915).

Next, a widow photolithography step 104 is performed to create a window for subsequent etching steps 106 and 108. The window photolithography step 104 and a photoresist removal step 110 (discussed below) are standard in any window formation sequence, as would be apparent to persons skilled in the semiconductor manufacturing art.

An isotropic window etching step 106 and an anisotropic window etching step 108 are then preformed to open the window in the oxide layer. The result of the implant (step 102) followed by the isotropic/anisotropic etch (steps 104, 106 and 108) is that the window walls have a concave-shaped profile. This profile facilitates superior step coverage for the aluminum which is deposited in a well known manner after removal of the photoresist, as shown in a step 110.

According to the preferred embodiment of the invention, the isotropic window etch step 106 is performed using an Aura model 2001 etcher (manufactured by Gasonics IPC, 2730 Junction Avenue, San Jose, California, 95134-1909), and the anisotropic window etch step 108 is performed using a model 384T Oxide Etcher (manufactured by Drytech, 3111 Coronado Drive, Santa Clara, California 95054).

According to the inventive method, the process variables used for an arsenic implant (step 102), for example, include an energy of between about 35-45 keV (preferably 40keV) and dose values ranging from 5E14 to 5E15 ions/cm², depending on component topography. The key result desired with the implant step 102 is to confine the implant damage to the top ∼500 Angstroms of the oxide.

Example operating conditions of the Aura 2001 Gasonics etcher for the isotropic window etch (step 106) are listed below in Table 1:

| **PARAMETER** | **SETTING** |
|---|---|
| CF₄ Flow Rate | 1.5 lpm |
| O₂ Flow Rate | 0.5 lpm |
| Pressure | 2 Torr |
| RF Power | 1000 W |
| Temperature | 90° C |
| Time | 5 sec |

| **Table 1** | |
|---|---|
| | |

Listed below in Table 2 are example operating conditions for the Drytech 384T etcher during the anisotropic portion (108) of the window etch:

| **PARAMETER** | **SETTING** |
|---|---|
| CHF₃ | 45 sccm |
| C₂F₆ | 5 sccm |
| Pressure | 140 mTorr |
| Time | 53 sec |
| RF Power | 400W |

| **Table 2** | |
|---|---|
| | |

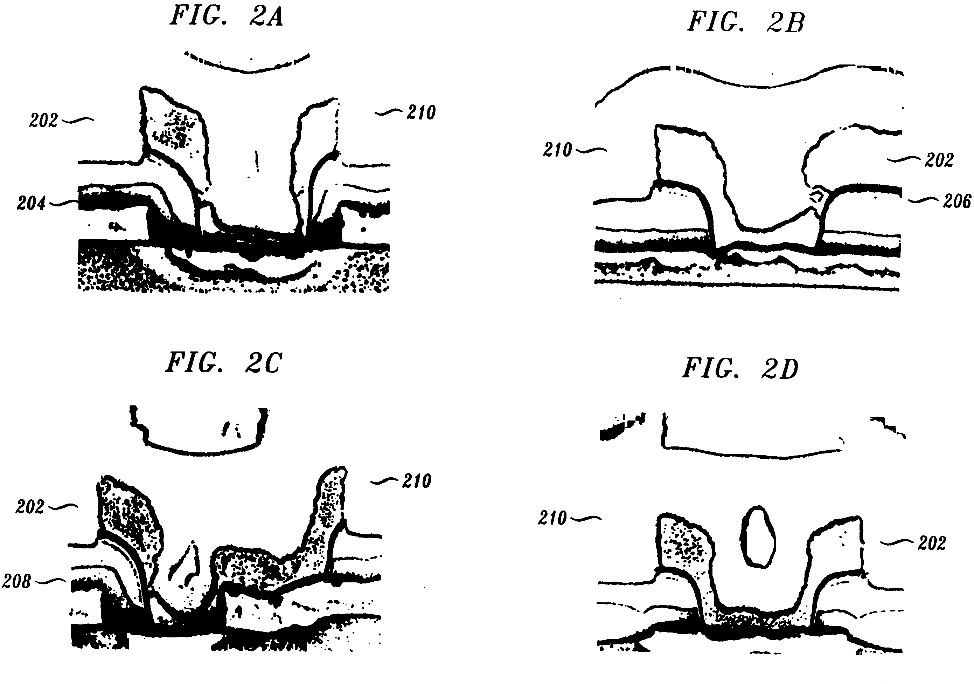

A comparison between step coverage results achieved according to the present invention with results from conventional reflow techniques will now be described with reference to Figures 2-4.

Figures 2A-2D show scanning electron microscope (SEM) cross-sectional view of the step coverage of aluminum (shown at 202) deposited according to a standard process consisting of isotropic/anisotropic window etches, followed by glass reflow to smooth the edges of the windows. No prior arsenic implant was preformed. As can be observed, the coverage is very poor, with sections of the metal becoming discontinuous at some points, as shown at 204, 206 and 208. Note that a passivation layer 210 formed of an oxide, epoxy or the like, is covering the aluminum 202.

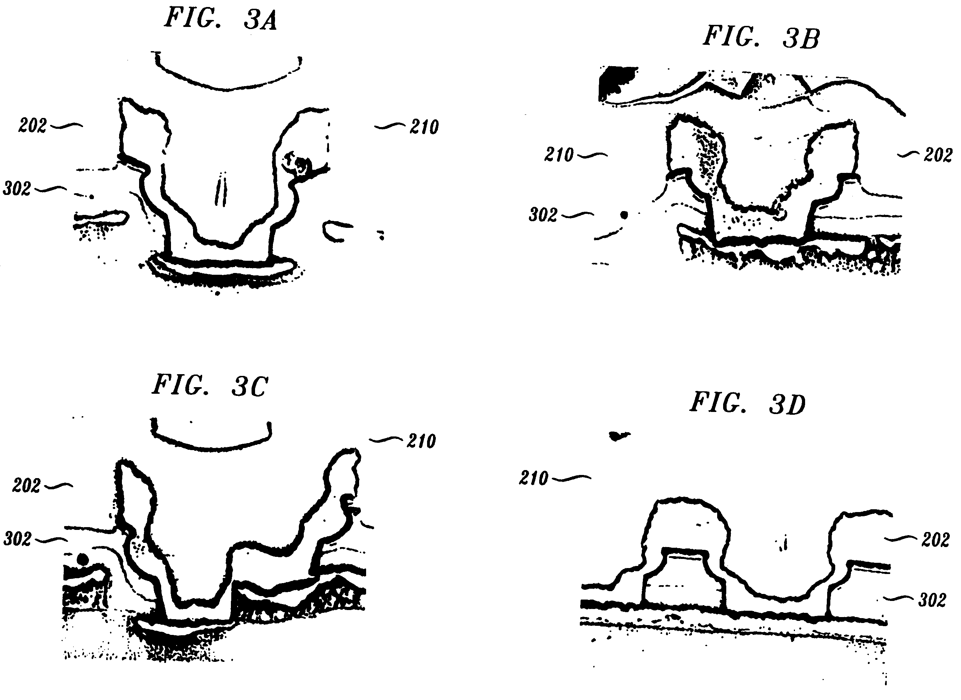

Figures 3A-3D show SEM cross-sections of typical windows from a second group of wafers. The second group of wafers had the windows etched by using the isotropic/anisotropic step, without prior arsenic implant. The glass was not reflowed. Although the aluminum step coverage is better than in the standard case show in Figures 2A-2D, sharp edges 302 on the top of the windows are clearly visible. In more severe topographies, the re-entrant edges could lead to metal discontinuities, or reliability failures.

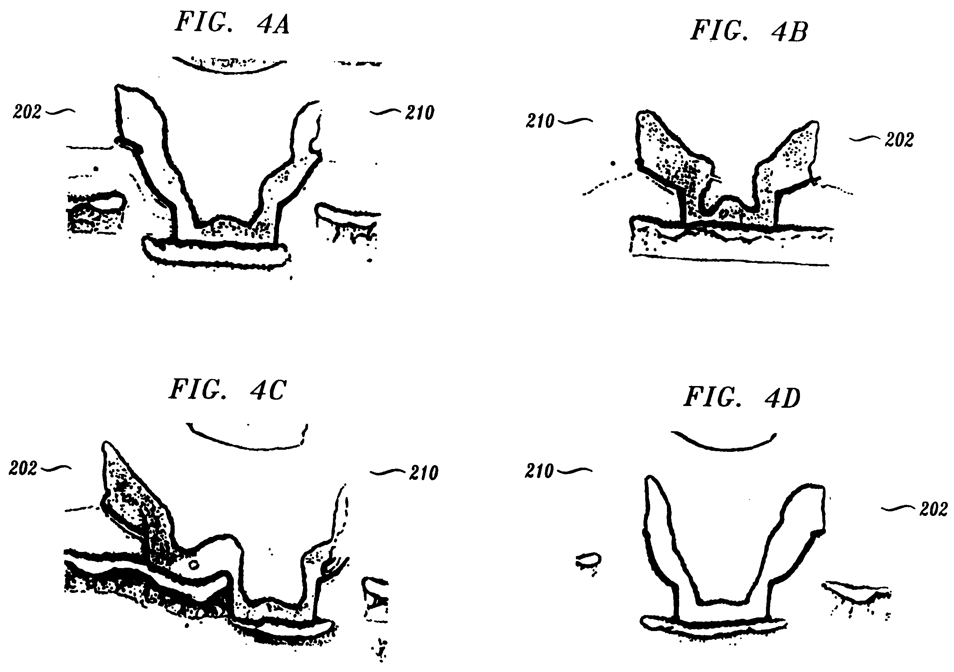

A third group of wafers had an arsenic implant (40 keV, 5E14 ions/cm²), followed by window patterning, and isotropic/anisotropic window etch, according to the present invention. Again, no glass reflow was used. Typical SEM cross-sections for the third group are show in Figures 4A-4D. The re-entrant edge is eliminated, and the profile is excellent for enhanced aluminum step coverage. Additionally, the component yield, and current-voltage characteristics of the third group of wafers are similar the standard processes.

While various embodiments of the present invention have been described above, it should be understood that they have been presented by way of example, and not limitation. It will be apparent to persons skilled in the relevant art that various changes in form and detail may be made therein without departing from the spirit and scope of the invention. Thus, the present invention should not be limited by any of the above-described exemplary embodiments, but should be defined only in accordance with the following claims and their equivalents. All cited patent documents and publications in the above description are incorporated herein by reference.

## Claims

1. A method for forming a contact window in an oxide layer formed on a semiconductor substrate, comprising the steps of:
(a) implanting a dopant into the oxide layer, followed by;
(b) isotropically etching a predetermined window area of the oxide layer; and
(c) anisotropically etching the window area;
wherein said steps (a)-(c) form the contact window in the oxide layer at the window area permitting a sub-micron linewidth contact layer to be formed within the contact window.

2. The method according to claim 1, further comprising the following step after step (a) and before step (b):
patterning a photoresist on the oxide layer to define the window area.

3. The method according to claim 2, further comprising the step of:
removing the photoresist after said anisotropically etching step.

4. The method according to claim 1, wherein step (a) comprises implanting arsenic.

5. The method according to claim 4, wherein the arsenic is implanted using an energy level of between 35 to 45 keV and a dose from between 5E14 to 5E15 ions/cm².

6. The method according to claim 1, wherein step (a) comprises implanting phosphorus.

7. The method according to claim 1, wherein step (a) comprises implanting silicon.

8. The method according to claim 1, further comprising the step of:
depositing aluminum in the window area.

9. The method according to claim 1, further comprising the steps of:
depositing a barrier layer in the window area; and then
depositing aluminum in the window area.
